# EUROPEAN PATENT APPLICATION

(11) **EP 2 053 634 A2**
(43) Date of publication of application: **29.04.2009**
(21) Application number: 08018486.4
(22) Date of filing: 22.10.2008
(51) Int. Cl.: H01L 21/00

(54) **Wireless illumination sensing assembly**

(30) Priority: 22.10.2007 US 999895 P; 14.10.2008 US 250692
(71) Applicant: Cyberoptics Semiconductor, Inc., Beaverton, OR 97005 (US)
(72) Inventor: Bonciolini, Dennis J., Tigard, OR 97224 (US); Schuda, Felix J., Saratoga, CA 95070 (US)
(74) Representative: Vossius & Partner

(57) **Abstract**

A wireless illumination sensing assembly for sensing a property of illumination within a semiconductor processing environment is provided. The sensing assembly has a power source and a wireless communication module coupled to the power source. Measurement circuitry is also provided. At least one illumination sensor having an electrical characteristic that varies with the property of illumination. The illumination sensor(s) is/are coupled to the measurement circuitry.

## Description

### BACKGROUND

Semiconductor fabrication generally refers to an array of various individual processes that transform a semiconductor wafer into hundreds or even thousands of microelectronic circuits used for today's electronic devices.

In order to impart the pattern of the desired electronic circuit onto the semiconductor substrate, a photolithography process is generally employed. During this process, the wafer is generally covered with a photoresistive material by a suitable process, such as spin coating. During spin coating, a viscous liquid solution is provided onto the wafer, which is subsequently spun very quickly to produce a thin layer of photoresistive material on the wafer. Once the photoresistive layer is prepared on the wafer substrate, the layer is exposed to intense light, which is passed through a reticle that has the desired pattern of the circuit traces, similar to the negative of a picture. The areas of photoresist not covered by a darkened portion of the reticle will become chemically altered by exposure to the bright light. This alteration makes the exposed portion of the photoresist able to withstand a subsequently-applied developer solution which removes non-exposed photoresist material thereby leaving a reversed image of the circuit trace. The subsequently-remaining photoresist material then resists further processing steps which can selectively add or remove material as desired.

During exposure of semiconductor wafers in the photolithography process, Excimer stepper/scanners are used to provide the intense light that exposes the photoresistive layer. Accordingly, the illumination uniformity must be acceptable to print very fine features on the substrate. As the circuits which control the Excimer stepper/scanners age, and even as the Excimer stepper/scanners themselves age, their intensity may change to some extent, becoming potentially brighter or dimmer than nominal. Should such changes fail to be accounted for in semiconductor manufacturing, yields can be adversely affected.

Accordingly, there is a need to provide a system that easily and accurately measures the illumination levels that are generally directed upon wafers during a photolithography process in wafer fabrication.

### SUMMARY

A wireless illumination sensing assembly for sensing a property of illumination within a semiconductor processing environment is provided. The sensing assembly has a power source and a wireless communication module coupled to the power source. Measurement circuitry is also provided. At least one illumination sensor having an electrical characteristic that varies with the property of illumination. The illumination sensor(s) is/are coupled to the measurement circuitry.

### BRIEF DESCRIPTION OF THE DRAWINGS

FIG. 1 is a diagrammatic view of a wireless wafer-like illumination sensing assembly in accordance with an embodiment of the present invention.
FIG. 2 is a wireless illumination sensing assembly in a form of a reticle in accordance with an embodiment of the present invention.
FIG. 3 is block diagram of a wireless illumination sensing assembly in accordance with an embodiment of the present invention.
FIG. 4 is a diagrammatic view of a wireless illumination sensing assembly communicating with an illumination controller of a semiconductor processing system in accordance with embodiments of the present invention.

### DETAILED DESCRIPTION OF ILLUSTRATIVE EMBODIMENTS

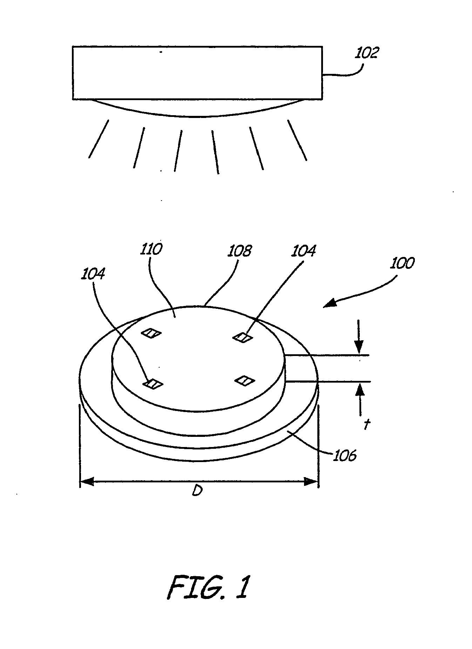

FIG. 1 is a diagrammatic view of a wireless wafer-like illumination sensing assembly in accordance with an embodiment of the present invention. As illustrated in FIG. 1, sensing assembly 100 is disposed to receive illumination from source 102 within a semiconductor processing environment. For example, source 102 can be an Excimer stepper/scanner that is used to expose the photosensitive layer, typically called photoresist, on a wafer. Preferably, sensing assembly 100 is sized in diameter (D) and thickness (t) similarly enough to an actual wafer that it can pass through the various apertures of the semiconductor processing environment using the same wafer handling equipment that handles a wafer. Exemplary diameters for sensor 100 are essentially the same diameters that are used for semiconductor wafers such as 200mm or 300mm diameters. Further, by making the diameter (D) and thickness (t) resemble a wafer, sensor 100 can potentially be stored in a front opening unified pod (FOUP) between testing and/or for recharging. Sensor 100 is preferably constructed from materials that act similarly to the semiconductor wafer that sensing assembly 100 approximates. Specifically, sensing assembly 100 can include silicon, and/or suitable metals such as aluminum.

Sensing assembly 100 includes base portion 106 that is substantially flat and of relatively uniform thickness. Base portion 106 can include additional features that add strength and/or reduce weight, as desired. Sensing assembly 100 also includes electronics compartment 108 housing the electronics for sensor 100 therein.

While FIG. 1 illustrates sensing assembly 100 including at least one illumination sensor 104, it is preferred that sensing assembly 100 include a plurality of illumination sensors 104 that are spaced from one another on surface 110 such that individual sensor measurements can be correlated with the respective positions of the various sensors to provide an indication of the illumination as a function of position. In particular, sensing assembly 100, illustrated in FIG. 1, includes four sensors 104 spaced from one another, but any suitable number, including one, can be employed.

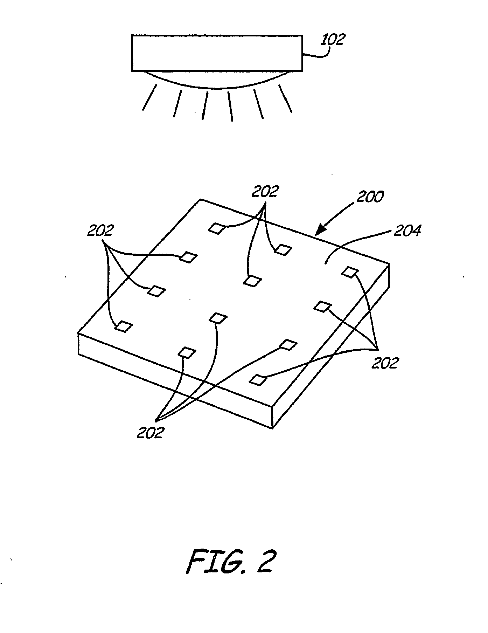

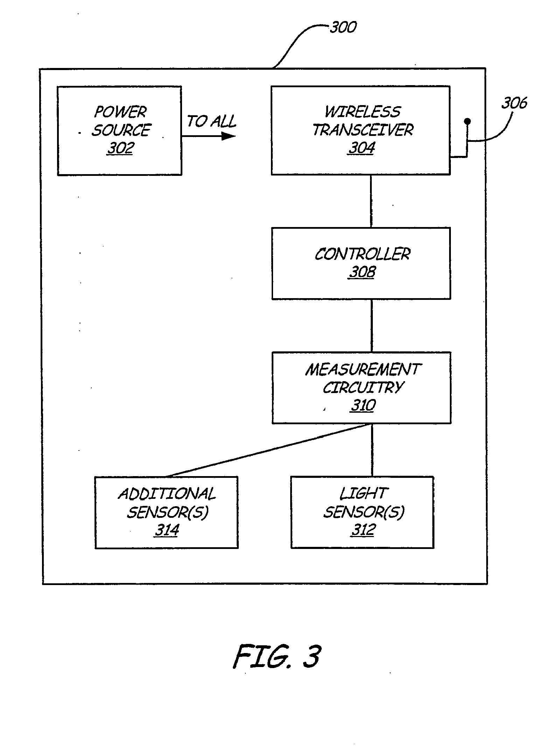

FIG. 2 is a diagrammatic view of a wireless illumination sensing assembly in accordance with an embodiment of the present invention. Sensing assembly 200 is illustrated in FIG. 2 in the form of a reticle, and more preferably a square reticle that is positionable in a stepper in order to measure, or otherwise observe, illumination in the reticle position in the semiconductor stepper. In general, a reticle is a 6x6 or 9x9 inch glass/quartz square that has an opaque or semi-transparent film thereon with a pattern of a circuit etched through the film. The reticle is inserted into a light path in the upper portion of the stepper, and generates the circuit pattern on a semiconductor, such as a semiconductor wafer. Thus, the reticle acts much like a negative in photographic printing. By providing a wireless illumination sensing assembly 200 in the form factor of a reticle, the illumination in the upper portion of the stepper can be directly measured and/or analyzed. As illustrated in FIG. 2, reticle sensing assembly 200 preferably has a square shape and one or more illumination sensors 202. Unlike sensor 100, sensing assembly 200 is preferably simply of a rectangular, and preferably square, shape with an internal volume that accommodates the various electronics, which will be described in more detail with respect to FIG. 3.

As illustrated in FIG. 2, it is preferred that a number of illumination sensors 202 be provided on surface 204 of sensing assembly 200 in order to obtain illumination measurements at various positions with respect to source 102. In this manner, illumination measurements for individual sensors 202 can be correlated with the position of the respective sensors 202 to provide additional information regarding the illumination as a function of position.

FIG. 3 is a diagrammatic view of a wireless illumination sensing assembly in accordance with an embodiment of the present invention. Sensing assembly 300 can be embodied in the form illustrated in FIG. 1, or FIG. 2, or some other form altogether. Sensing assembly 300 includes power source 302 which is coupled to the various electrical components of sensing assembly 300. Preferably, power source 302 is a rechargeable battery, or supercapacitor, that is able to acquire and store sufficient energy to provide illumination sensing until sensing assembly 300 is charged again. Additionally, or alternatively, power source 302 can include one or more photovoltaic cells configured to receive some of the illumination from source 102 to provide some, or all operating power needed for sensing assembly 300.

Sensing assembly 300 also includes wireless transceiver 304 which is coupled to antenna 306. Antenna 306 may be external to an electronics compartment, or may be disposed within an electronics compartment proximate a radio-transparent window, or other suitable arrangement. Wireless transceiver 304 preferably uses a standard wireless communication in accordance with a standard protocol, such as the Bluetooth standard and/or other wireless communication techniques such as WiFi (wireless fidelity) or other radio frequency technology. Wireless transceiver 304 is coupled to controller 308 which is preferably a microprocessor. However, controller 308 can be any suitable circuit arrangement that is able to calculate or otherwise provide information regarding the various light sensors to an external device via wireless transceiver 304. In a preferred embodiment, controller 308 may store a number of illumination sensor readings for each illumination sensor over time such that temporal variations of illumination can be measured or otherwise discerned. Further, in embodiments where a number of illumination sensors are used that are spatially separated from on another upon the sensor, storing a number of temporally spaced respective sensor measurements can provide a detailed profile of illumination varying both spatially and temporally.

Controller 308 is preferably coupled to measurement circuitry 310 which can include any suitable circuitry for measuring electrical characteristics of one or more illumination sensors. Further, measurement circuitry 310 can include known analog-to-digital converters and/or multiplexers to address a number of various illumination sensors. As illustrated in FIG. 3, measurement circuitry 310 is operably coupled to one or more light sensors 312. Light sensors 312 can be any suitable sensors, including photodetectors, capable of detecting illumination emanating from source 102. Preferably, sensors 312 are capable of detecting intensity and uniformity of wavelengths in the 193 nm and 248 nm range as well as other ranges that might be applicable, over roughly a 30mm x 30mm area in potentially multiple locations on a substrate-like device.

In some embodiments the photodetectors are solid state detectors such as: modified silicon p-n diodes, GaN, SiC or diamond photodiodes. However, there are many possible illumination detectors that can be used in accordance with embodiments of the present invention. Further, the illumination detectors need not be the same model, or even of the same type of detector. Additionally, filters can be used to modify the spectral response curve. Ultraviolet (UV) phosphors and/or diffusers can also be used. Because of the short wavelengths involved, it may also be preferable to omit any window or covering over the various light sensors 312. In addition, in order to negate temperature coefficients of photodiodes, a temperature sensor can be placed near each individual photodiode, which temperature sensor would be considered an "additional sensor" as illustrated diagrammatically in block 314. Additional sensors 314, in addition to the temperature sensor described above, can also be used to sense any desired parameters. For example, such sensors can include chemical sensors, pressure sensors, acoustic sensors, humidity sensors, or any other suitable sensors.

Illumination sensors 312 can be adapted to sense various characteristics of the illumination. For example, an illumination sensor 312 may sense illumination intensity as a function of position, in what would be termed spatial characteristics. Alternatively, or additionally, one or more illumination sensors 312 may sense spectral characteristics of the illumination. Still further, alternatively or additionally, the illumination sensor could sense temporal characteristics of the illumination over time, as described above. Thus, intensity as a function of position and time could be studied; spectral characteristics as a function of position and/or time can be studied; and the combination could be studied as well.

Illumination sensors 312 can be used in combination with any suitable optical elements to change focus/field of view, or any other suitable parameters. Additionally, the optical elements can facilitate the distinction of illumination of different wavelengths using suitable filters, et cetera as may be desired.

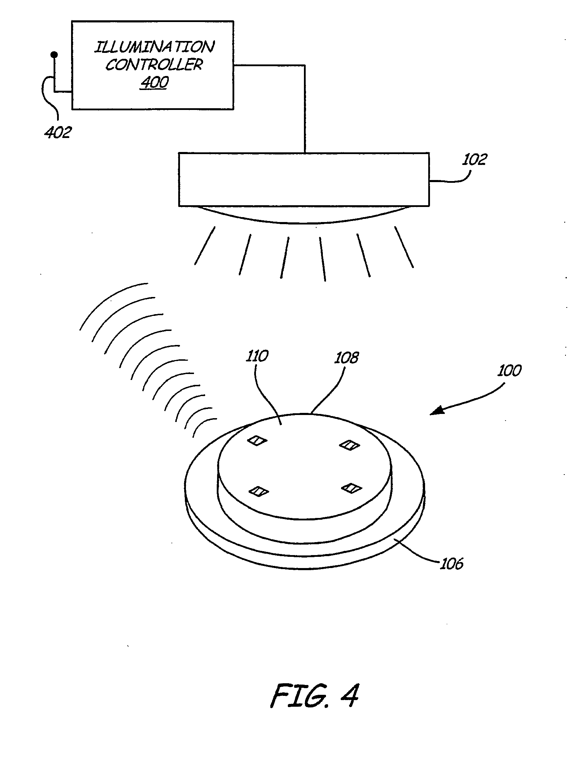

FIG. 4 is a diagrammatic view of a wireless illumination sensing assembly communicating with an illumination controller of a semiconductor processing system in accordance with embodiments of the present invention. FIG. 4 illustrates sensing assembly 100 but any sensing assembly, including sensor 200 (shown in FIG. 2), could be used in accordance with the embodiment illustrated in FIG. 4. Sensing assembly 100 communicates information wirelessly to illumination controller 400, which controller 400 is adapted for wireless communication using antenna 402. Illumination controller 400 receives information from sensor 100 relative to the illumination intensity or any other suitable characteristic of illumination emanating from source 102, and adjusts, or otherwise compensates, signals to source 102 via control line 404. In this manner, real time illumination control and/or compensation can be provided in accordance with embodiments of the present invention.

Embodiments of the present invention generally provide real time reporting of illumination uniformity directly from the scanner shot pattern and allow direct adjustment of the lamp and/or optics to achieve the desired resolution in less time. The sensing assemblies in accordance with embodiments of the present invention can be adapted for in situ charging in a charging FOUP so that such sensors can be run hands-off any time or on some preset interval by the fab engineers and technicians.

Further still, optical fibers can be used to transport illumination from the sensing area to the detectors. These fibers may be also used to modify the spatial and/or spectral characteristics of the illumination.

Although the present invention has been described with reference to preferred embodiments, workers skilled in the art will recognize that changes may be made in form and detail without departing from the spirit and scope of the invention. For example, while embodiments of the present invention have generally been directed toward visible or near visible illumination, embodiments of the present invention can be practiced with other wavelengths of electromagnetic radiation.

## Claims

1. A wireless illumination sensing assembly for sensing a property of illumination within a semiconductor processing environment, the assembly comprising:
a power source;
a wireless communication module coupled to the power source;
measurement circuitry operably coupled to the wireless communication module; and
at least one illumination sensor having an electrical characteristic that varies with the property of illumination, the at least one illumination sensor being coupled to the measurement circuitry.

2. The assembly of claim 1, and further comprising a controller coupled to the power source and the wireless communication module.

3. The assembly of claim 1 or 2, wherein the assembly is embodied in the form of a wafer.

4. The assembly of claim 1 or 2, wherein the assembly is embodied in the form of a reticle.

5. The assembly of any one of the preceding claims, wherein the at least one illumination sensor includes a photodetector.

6. The assembly of claim 5, wherein the photodetector is a solid state photodetector.

7. The assembly of claim 6, wherein the solid state photodetector is a modified silicon p-n diode.

8. The assembly of claim 6, wherein the solid state photodetector is a GaN photodiode.

9. The assembly of claim 6, wherein the solid state photodetector is a SiC photodiode.

10. The assembly of claim 6, wherein the solid state photodetector is a diamond photodiode.

11. The assembly of any one of the preceding claims, wherein the at least one illumination sensor includes a plurality of illumination sensors spaced from one another.

12. The assembly of claim 11, wherein the at least one illumination sensor is sensitive to a different aspect of the illumination than another illumination sensor.

13. The assembly of any one of claims 2 to 12, wherein the controller is configured to store multiple measurements relative to each respective illumination sensor.

14. The assembly of any one of the preceding claims, wherein the power source is a rechargeable power source.

15. The assembly of any one of the preceding claims, wherein the wireless communication module is configured to provide bi-directional radio-frequency communication.

16. A method of adjusting illumination of an illumination source in a semiconductor processing environment, the method comprising:
placing a wireless illumination sensor within a semiconductor processing environment to receive at least some of the illumination;
measuring the illumination with the wireless illumination sensor;
communicating information regarding the illumination to an illumination controller wirelessly; and
adjusting a control signal to an illuminator in the semiconductor processing environment based upon the wirelessly-communicated information.
